# EUROPÄISCHE PATENTSCHRIFT

(11) **EP 0 789 944 B1**
(45) Veröffentlichungstag und Bekanntmachung des Hinweises auf die Patenterteilung: **16.06.1999**
(21) Anmeldenummer: 95934661.0
(22) Anmeldetag: 07.10.1995
(51) Int. Cl.: H02B 1/01, H05K 7/18, F16B 12/50, A47B 47/02

(54) **RAHMENGESTELL AUS RAHMENSCHENKELN UND TIEFENSTREBEN**
FRAME FOR A SWITCHGEAR CABINET
BAIE FORMEE DE MONTANTS ET D'ENTRETOISES DE PROFONDEUR

(30) Priorität: 05.11.1994 DE 4439628
(43) Veröffentlichungstag der Anmeldung: 20.08.1997
(73) Patentinhaber: Rittal-Werk Rudolf Loh GmbH & Co. KG, 35745 Herborn (DE)
(72) Erfinder: BESSERER, Horst, D-35745 Herborn (DE); HARTEL, Marc, D-35447 Reiskirchen (DE); ZACHRAI, Jürgen, D-35690 Dillenburg (DE)
(74) Vertreter: Fleck, Hermann-Josef, Dr.-Ing.
(86) Internationale Anmeldenummer: EP9503959
(87) Internationale Veröffentlichungsnummer: WO9614679

(56) Entgegenhaltungen:
- EP-A- 0 420 676
- DE-A- 1 591 480
- DE-A- 4 017 511
- DE-U- 9 406 149
- FR-A- 1 601 944
- FR-A- 2 207 402

## Beschreibung

Die Erfindung betrifft ein Rahmengestell aus horizontalen und vertikalen Rahmenschenkeln gemäß dem Oberbegriff des Anspruchs 1 (vgl DE-A-1 591 480). Bei einer Vielzahl von Rahmengestellen sind die Rahmenschenkel und die Tiefenstreben aus demselben Profilstrang oder demselben Hohlprofil hergestellt. Zum Zusammenbau des Rahmengestelles sind zusätzliche Eckverbinder erforderlich, die mit Steckansätze in Steckaufnahmen der Rahmenschenkel und Tiefenstreben eingeführt und darin festgelegt sind. Diese Eckverbinder sind speziell hergestellte Teile, die den Aufwand für das Rahmengestell beachtlich vergrößern. Die Rahmenschenkel sind dabei selbst mit Befestigungsmöglichkeiten für Montageschienen, Bauteile und dgl. versehen, was deren Herstellung noch einmal verteuert. Vielfach sind derartige, über die gesamte Länge der Rahmenschenkel verteilte Befestigungsmöglichkeiten gar nicht erforderlich.

Es ist Aufgabe der Erfindung, ein Rahmengestell der eingangs erwähnten Art zu schaffen, das mit wenigen einfachen, vorzugsweise auch handelsüblichen Teilen schnell aufgebaut werden kann, ohne auf die Anbringung von Montageschienen, Bauteilen und dgl. an den vertikalen und horizontalen Rahmenschenkeln verzichten zu müssen.

Diese Aufgabe wird durch die Merkmale des Anspruchs 1 gelöst.

Bei diesem Rahmengestell wird nur ein Strangpreßprofilstrang benötigt, von dem die horizontalen und vertikalen Rahmenschenkel abgelängt werden. Diese Strangpreßprofilabschnitte weisen einstückig angeformte Schraubaufnahmen und Befestigungsnuten auf. Die Tiefenstreben werden von einem handelsüblichen Winkelprofilstrang abgelängt und einfach mit den horizontalen und vertikalen Rahmenschenkeln verschraubt. Die Befestigungsnuten sind vorzugsweise hinterschnitten, so daß sie Befestigungsmittel unverlierbar aufnehmen können. Auf diese Weise ist über die gesamte Länge der Rahmenschenkel eine Befestigungsmöglichkeit, z.B. für Befestigungsflansche, Gleitschienen, Teleskopschienen und dgl., geschaffen, so daß Baugruppenträger, Gehäuse und dgl. in das Rahmengestell eingebaut werden können.

Ist vorgesehen, daß die Tiefenstreben an den Verbindungsbereichen mit den Rahmenschenkeln mittels Eckstücken oder über ihre gesamte Länge mittels Eckleisten abgedeckt sind, die einen dreieckförmigen Querschnitt aufweisen und den Raum zwischen den Schenkeln der Tiefenstreben ausfüllen, dann kann das Rahmengestell im Bereich der Tiefenstreben sauber abgedeckt werden.

Die Verbindungsstellen an den Rahmenschenkeln werden vorzugsweise so gelegt, daß die Schraubaufnahmen innerhalb der Außenkontur der im Querschnitt im wesentlichen rechteckförmigen Rahmenschenkel angeordnet sind.

Eine eindeutige, verdrehsichere Verbindung zwischen den Tiefenstreben und den Rahmenschenkeln ergibt sich dadurch, daß die Rahmenschenkel mindestens zwei im Abstand zueinander parallel verlaufende Schraubaufnahmen aufweisen und die durch Bohrungen der Schenkel der Tiefenstreben geführten Befestigungsschrauben aufnehmen.

An der Vorderseite und der Rückseite des Rahmengestelles läßt sich dadurch ein bündiger Abschluß erreichen, daß die Schenkel der Tiefenstreben und die Eckstücke oder Eckleisten bündig mit den angrenzenden vorderen bzw. hinteren Außenschmalseiten der Rahmen abschließen.

Der saubere Abschluß des Rahmengestelles nach außen wird dadurch noch verbessert, daß die Schenkel der Tiefenstreben mit den freien Längskanten bündig mit den Außen-Breitseiten der Rahmenschenkel abschließen. Die Eckstücke oder die Eckleisten haben dabei vorzugsweise dreieckförmigen Querschnitt.

Ist vorgesehen, daß die Tiefenstreben, die Eckstücke und/oder die Eckleisten über die Vorder- und/oder Rückseite des Rahmengestelles vorstehen, dann kann an der Vorder- und/oder Rückseite des Rahmengestelles eine Türe angeschlagen werden.

Damit eine umlaufende Abdichtung erzielt werden kann, ist vorgesehen, daß die Tiefenstreben, die Eckstücke und/oder die Eckleisten im Bereich ihrer Innenkante einen bis zur Vorder- und/oder Rückseite des Rahmengestelles zurückgesetzten Absatz für die Anlage eines Dichtungselementes tragen.

Der Einbau von Baugruppenträgern, Gehäusen und dgl. in das Rahmengestell wird dadurch erleichtert, daß die Befestigungsnuten auf den einander zugekehrten Innen-Breitseiten der die Rahmen bildenden Rahmenschenkel angeordnet sind.

Die Erfindung wird anhand eines in den Zeichnungen dargestellten Ausführungsbeispiels näher erläutert. Es zeigen:
Fig. 1 in perspektivischer Ansicht das zusammengesetzte Rahmengestell und
Fig. 2 in Explosionsdarstellung die Verbindung eines horizontalen und eines vertikalen Rahmenschenkels mit einer Tiefenstrebe im Eckbereich des Rahmengestelles.

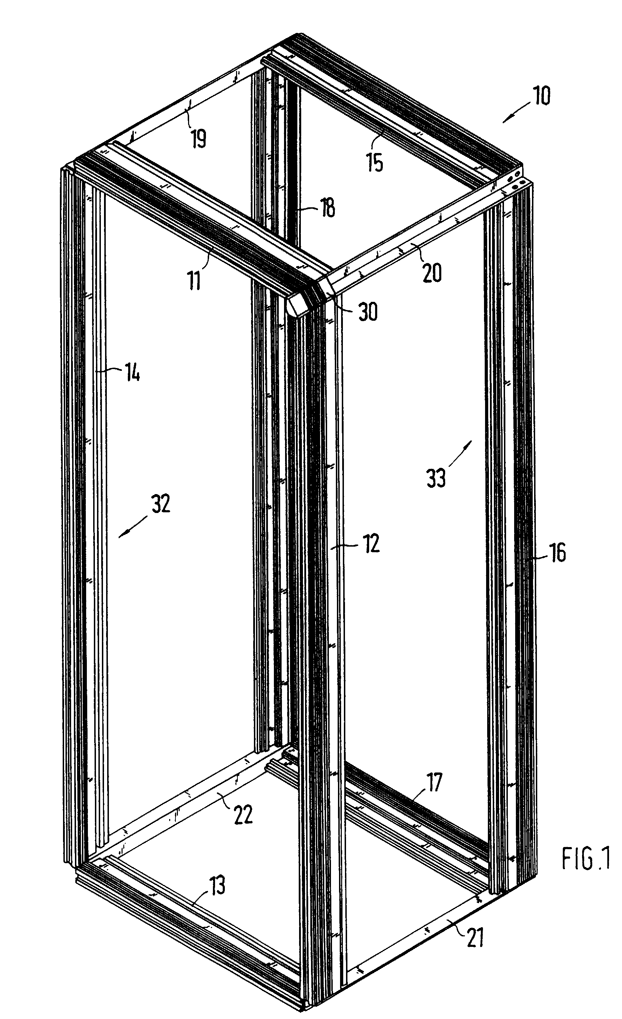

Das Rahmengestell 10 ist, wie Fig. 1 zeigt, aus einem vorderen Rahmen 32 und einem hinteren Rahmen 33 gebildet. Der Rahmen 32 besteht aus den horizontalen Rahmenschenkeln 11 und 13 sowie den vertikalen Rahmenschenkeln 12 und 14. Der hintere Rahmen 33 besteht aus den horizontalen Rahmenschenkeln 15 und 17 und den vertikalen Rahmenschenkeln 16 und 18. Die beiden Rahmen 32 und 33 sind in ihren Eckbereichen mittels vier Tiefenstreben 19, 20, 21 und 22 miteinander verbunden.

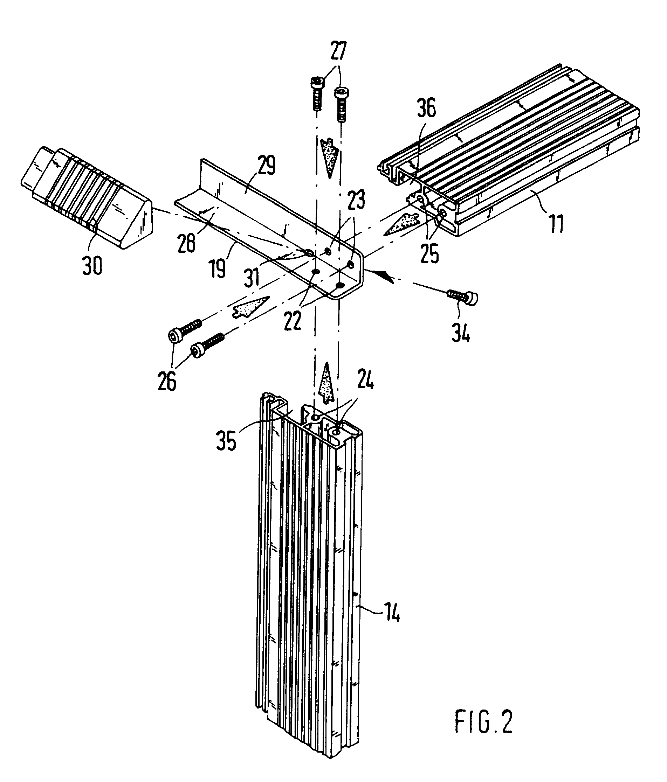

Die Verbindung in einem Eckbereich ist der Fig. 2 zu entnehmen. Daraus ist zu ersehen, daß die Rahmenschenkel alle als Abschnitte eines Strangpreßabschnittes ausgebildet sind. Ihr Querschnitt ist im wesentlichen rechteckförmig, wobei Schmalseiten der Vorder- und der Rückseite des Rahmengestelles 10 zugekehrt sind. Innerhalb der Außenkontur der Rahmenschenkel 11 bis 18 sind zwei im Abstand zueinander stehende, durchgehende Schraubaufnahmen eingeformt, wie die Schraubaufnahmen 24 am vertikalen Rahmenschenkel 14 und mit den Schraubaufnahmen 25 am horizontalen Rahmenschenkel 11 erkennbar ist. Daraus ist zu ersehen, daß in Fig. 2 die obere linke Ecke des Rahmengestelles 10 erläutert wird. Außerdem sind in die Rahmenschenkel 11 bis 18 durchgehende Befestigungsnuten 35 und 36 eingeformt, die auf den einander zugekehrten Innen-Breitseitenwänden der Rahmen 32 und 33 angeordnet und vorzugsweise hinterschnitten sind, um Befestigungsmittel unverlierbar aufnehmen zu können.

Die Tiefenstreben 19 bis 22 sind als Abschnitte eines handelsüblichen Winkelprofilstranges ausgebildet, bei dem die beiden Schenkel 28 und 29 im rechten Winkel zueinander stehen. Über die Bohrungen 22 und 23 in den Schenkeln 28 und 29 können der horizontale und der vertikale Rahmenschenkel 11 und 14 mittels der Befestigungsschrauben 26 und 27 an den Schenkeln 28 und 29 der Tiefenstrebe 19 angeschraubt werden, wobei die Befestigungsschrauben 26 und 27 in die Schraubaufnahmen 24 und 25 eingeschraubt werden. Dabei schließen die Stirnseiten der Schenkel 28 und 29 bündig mit den Schmalseiten der Rahmenschenkel 11 bis 18 auf der Vorder- und Rückseite des Rahmengestelles 10 ab. Die freien Längskanten der Schenkel 28 und 29 schließen bündig mit den Außen-Breitseiten der Rahmenschenkel 11 bis 18 ab.

Sollen die Verbindungsstellen abgedeckt werden, dann können die Verbindungsbereiche in den Ecken der Rahmen 32 und 33 mittels im Querschnitt dreieckförmigen Eckstücken 30 abgedeckt werden, die mittels einer Schraube 34 über die Bohrung 31 der Tiefenstrebe 19 in das Eckstück 30 eingeschraubt wird. Diese Eckstücke 30 füllen den Raum zwischen den Schenkeln 28 und 29 der Tiefenstreben 19 bis 22 aus. Anstelle der Eckstücke können mittels Eckleisten gleichen Querschnitts die Tiefenstreben 19 bis 22 auch über ihre gesamte Länge abgedeckt werden.

Soll auf der Vorder- und/oder Rückseite eine Türe angebracht werden, dann stehen die Tiefenstreben 19 bis 22, die Eckstücke 30 und/oder die Eckleisten an der Vorder- und/oder Rückseite der Rahmen 32 und/oder 33 ab und bilden Scharnier- und Schließmöglichkeiten. Die Innenecke der Tiefenstreben 19 bis 22, der Eckstücke 30 und/oder der Eckleisten ist dann abgesetzt und bildet im Bereich der Vorder- und/oder Rückseite der Rahmen 32 und/oder 33 mit der Vorderseite des Rahmens 32 und/oder der Rückseite des Rahmens 33 umlaufende Anlageflächen mit den Schmalseiten der Rahmen 32 und 33 für ein Dichtungselement.

## Patentansprüche

1. Rahmengestell aus horizontalen und vertikalen Rahmenschenkeln (11, 12, 13, 14, 15, 16, 17, 18), die einen vorderen und hinteren Rahmen (32, 33) bilden, wobei die Rahmen (32, 33) mittels Tiefenstreben (19, 20, 21, 22) in den Eckbereichen der Rahmen (32, 33) miteinander verbunden sind, wobei die horizontalen und vertikalen Rahmenschenkel (11,13 und 12,14 bzw. 15,17 und 16,18) der Rahmen (32,33) als Strangpreß-Profilabschnitte mit durchgehend an- oder eingeformten Befestigungsnuten (35,36) und Schraubaufnahmen (24,25) ausgebildet sind, und wobei die an den Ecken aufeinanderstoßenden Rahmenschenkel (11,12; 12,13; 13,14; 14,11 bzw. 15,16; 16,17; 17,18; 18,15) mittels Befestigungsschrauben (26,27) mit den Tiefenstreben (19 bis 22) verschraubt sind, dadurch gekennzeichnet, daß die Tiefenstreben (19,20, 21,22) als Winkelprofilabschnitte mit rechtwinklig zueinander stehenden Schenkeln (28,29) ausgebildet sind, die mit den an den Ecken aufeinanderstoßenden Rahmenschenkel (11, 12, 13, 14, 15, 16, 17, 18) verschraubt sind.

2. Rahmengestell nach Anspruch 1,
dadurch gekennzeichnet,
daß die Tiefenstreben (19 bis 22) an den Verbindungsbereichen mit den Rahmenschenkeln (11 bis 18) mittels Eckstücken (30) oder über ihre gesamte Länge mittels Eckleisten abgedeckt sind, die einen vorzugsweise dreieckförmigen Querschnitt aufweisen und den Raum zwischen den Schenkeln (28,29) der Tiefenstreben (19 bis 22) ausfüllen.

3. Rahmengestell nach Anspruch 1 oder 2,
dadurch gekennzeichnet,
daß die Schraubaufnahmen (24,25) innerhalb der Außenkontur der im Querschnitt im wesentlichen rechteckförmigen Rahmenschenkel (11 bis 18) angeordnet sind.

4. Rahmenschenkel nach einem der Ansprüche 1 bis 3,
dadurch gekennzeichnet,
daß die Rahmenschenkel (11 bis 18) mindestens zwei im Abstand zueinander parallel verlaufende Schraubaufnahmen (24 bzw. 25) aufweisen und die durch Bohrungen (22,23) der Schenkel (28,29) der Tiefenstreben (19 bis 22) geführten Befestigungsschrauben (26,27) aufnehmen.

5. Rahmenschenkel nach einem der Ansprüche 1 bis 4,
dadurch gekennzeichnet,
daß die Schenkel (28,29) der Tiefenstreben (19 bis 22) und die Eckstücke (30) oder Eckleisten bündig mit den angrenzenden vorderen bzw. hinteren Außenschmalseiten der Rahmen (32,33) abschließen.

6. Rahmenschenkel nach einem der Ansprüche 1 bis 5,
dadurch gekennzeichnet,
daß die Schenkel (28,29) der Tiefenstreben (19 bis 22) mit den freien Längskanten bündig mit den Außen-Breitseiten der Rahmenschenkel (11 bis 18) abschließen.

7. Rahmenschenkel nach einem der Ansprüche 1 bis 6,
dadurch gekennzeichnet,
daß die Eckstücke (30) oder Eckleisten im Querschnitt vorzugsweise dreieckförmig sind.

8. Rahmengestell nach einem der Ansprüche 1 bis 7,
dadurch gekennzeichnet,
daß die Tiefenstreben (19 bis 22), die Eckstücke (30) und/oder die Eckleisten über die Vorder- und/oder Rückseite des Rahmengestelles (10) vorstehen.

9. Rahmengestell nach Anspruch 8,
dadurch gekennzeichnet,
daß die Tiefenstreben (19 bis 22), die Eckstücke (30) und/oder die Eckleisten im Bereich ihrer Innenkante einen bis zur Vorder- und/oder Rückseite des Rahmengestelles (10) zurückgesetzten Absatz für die Anlage eines Dichtungselementes tragen.

10. Rahmengestell nach einem der Ansprüche 1 bis 9,
dadurch gekennzeichnet,
daß die Befestigungsnuten (35,36) auf den einander zugekehrten Innen-Breitseiten der die Rahmen (32,33) bildenden Rahmenschenkel (11 bis 14 bzw. 15 bis 18) angeordnet sind.

## Claims

1. Framework, comprising horizontal and vertical frame members (11,12,13,14,15,16,17,18), which form a front and rear frame (32,33), the frames (32,33) being interconnected by means of depth bars (19,20,21,22) in the corner regions of the frames (32,33), the horizontal and vertical frame members (11,13 and 12,14 or respectively 15,17 and 16,18) of the frames (32,33) being configured as extruded profiled sections provided with mounting grooves (35,36) and screw receivers (24,25) continuously moulded thereon or therein, and the frame members (11,12; 12,13; 13,14; 14,11 or respectively 15,16; 16,17; 17,18; 18,15) which abut against the corners being screw-connected to the depth bars (19 to 22) by means of securing screws (26,27), characterised in that the depth bars (19,20, 21,22) are configured as angular profiled sections provided with portions (28,29), which extend at right angles relative to each other and are screw-connected to the frame members (11,12,13,14,15,16, 17,18) which abut against the corners.

2. Framework according to claim 1, characterised in that the depth bars (19 to 22) are covered at the junctions with the frame members (11 to 18) by means of corner pieces (30) or by means of corner strips over their entire length, which corner strips have a preferably triangular cross-section and fill the space between the portions (28,29) of the depth bars (19 to 22).

3. Framework according to claim 1 or 2, characterised in that the screw receivers (24,25) are disposed internally of the external configuration of the frame members (11 to 18), which have a substantially rectangular cross-section.

4. Framework according to one of claims 1 to 3, characterised in that the frame members (11 to 18) have at least two screw receivers (24 and 25 respectively), which extend parallel to each other with a spacing therebetween and accommodate the securing screws (26,27), which extend through bores (22,23) in the portions (28,29) of the depth bars (19 to 22).

5. Framework according to one of claims 1 to 4, characterised in that the portions (28,29) of the depth bars (19 to 22) and the corner pieces (30) or corner strips terminate flush with the adjacent front or rear narrow external sides of the frames (32,33).

6. Framework according to one of claims 1 to 5, characterised in that, with their free longitudinal edges, the portions (28,29) of the depth bars (19 to 22) terminate with the wide external sides of the frame members (11 to 18).

7. Framework according to one of claims 1 to 6, characterised in that the corner pieces (30) or corner strips have a preferably triangular cross-section.

8. Framework according to one of claims 1 to 7, characterised in that the depth bars (19 to 22), the corner pieces (30) and/or the corner strips protrude beyond the front and/or rear side of the framework (10).

9. Framework according to claim 8, characterised in that the depth bars (19 to 22), the corner pieces (30) and/or the corner strips are provided, in the region of their internal edge, with a shoulder portion, which is set-back as far as the front and/or rear side of the framework (10), for the installation of a sealing element.

10. Framework according to one of claims 1 to 9, characterised in that the mounting grooves (35,36) are disposed on the wide internal sides, facing one another, of the frame members (11 to 14 or respectively 15 to 18), which form the frames (32,33).

## Revendications

1. Baie ou ossature comprenant des montants horizontaux et verticaux (11, 12, 13, 14, 15, 16, 17, 18), qui forment un cadre avant et un cadre arrière (32, 33), où les cadres (32, 33) sont mutuellement reliés au moyen d'entretoises de profondeur (19, 20, 21, 22) dans les zones d'angle des cadres (32, 33), où les montants horizontaux et verticaux (11, 13 et 12, 14 ou 15, 17 et 16, 18) des cadres (32, 33) ont la forme de tronçons de profilés extrudés avec des rainures de fixation (35, 36) formées en continu et avec des logements récepteurs pour vis (24, 25), et où les montants et traverses venant buter l'une sur l'autre aux angles (11, 12; 12, 13; 13, 14;14, 11 ou 15, 16; 16, 17; 17, 18; 18, 15) sont au moyen de vis de fixation (26, 17) assemblés par vissage aux entretoises de profondeur,
caractérisée
en ce que les entretoises de profondeur (19, 20, 21, 22) ont la forme de tronçons de profilé en cornière avec des ailes (28, 19) à ailes perpendiculaires l'une à l'autre, qui sont assemblés par vis aux traverses et montants (11, 12, 13, 14, 15, 16, 17, 18) venant buter l'une sur l'autre aux angles.

2. Baie ou ossature suivant la revendication 1,
caractérisée
en ce que dans les zones de liaison avec les montants et traverses (11 à 18), les entretoises de profondeur sont recouverts par des pièces d'angle (30) ou sont sur toute leur longueur par des lattes d'angle, qui présentent une section transversale de préférence de forme triangulaire et qui occupent l'espace entre les ailes (28, 29) des entretoises de profondeur (19 à 22).

3. Baie ou ossature suivant la revendication 1 ou 2,
caractérisée
en ce que les logements pour vis (24, 25) sont disposés à l'intérieur du contour extérieur des travers ou montants (11 à 18) à section transversale en substance de forme rectangulaire.

4. Baie ou ossature suivant l'une quelconque des revendications de 1 à 3,
caractérisée
en ce que les montants et traverses (11 à 18) présentent au moins deux logements pour vis (24 ou 25) orientés parallèlement et distants l'un de l'autre, qui reçoivent des vis de fixation (26, 27) guidées au travers des forures (22, 23) dans les ailes (28, 29) des entretoises de profondeur (19 à 22).

5. Baie ou ossature suivant l'une quelconque des revendications de 1 à 4,
caractérisée
en ce que les ailes (28, 29) des entretoises de profondeur (19 à 22) et les pièces d'angle (30) ou lattes d'angle se terminent à fleur des petits côtés extérieurs avant et arrière contigus des cadres (32, 33).

6. Baie ou ossature suivant l'une quelconque des revendications de 1 à 5,
caractérisée
en ce que les ailes (28, 29) des entretoises de profondeur (19 à 22) se terminent par leurs arêtes longitudinales libres à fleur avec les grands côtés extérieurs des montants et traverses (11 à 18).

7. Baie ou ossature suivant l'une quelconque des revendications de 1 à 6,
caractérisée
en ce que les pièces d'angle (30) ou lattes d'angle ont une section transversale de préférence de forme triangulaire.

8. Baie ou ossature suivant l'une quelconque des revendications de 1 à 7,
caractérisée
en ce que les entretoises de profondeur (19 à 22), les pièces d'angle (30) et/ou les lattes d'angle font protubérance sur la face avant et/ou arrière de la baie ou de l'ossature (10).

9. Baie ou ossature suivant la revendication 8,
caractérisée
en ce que en ce que les entretoises de profondeur (19 à 22), les pièces d'angle (30) et/ou les lattes d'angle présentent à leur arête intérieure un gradin en retrait jusqu'à la face avant et/ou arrière de l'ossature (10), gradin destiné à l'application d'un élément d'étanchéité.

10. Baie ou ossature suivant l'une quelconque des revendications de 1 à 9,
caractérisée
en ce que les rainures de fixation (35, 36) sont disposées dans les grands côtés intérieurs se faisant face des montants et traverses (11 à 14 ou 15 à 18) qui constituent les cadres (32, 33).
